# EUROPÄISCHE PATENTSCHRIFT

(11) **EP 2 326 742 B1**
(45) Veröffentlichungstag und Bekanntmachung des Hinweises auf die Patenterteilung: **07.11.2018**
(21) Anmeldenummer: 09777791.6
(22) Anmeldetag: 10.08.2009
(51) Int. Cl.: C23C 14/32, C23C 14/06, C23C 14/34, C23C 14/08

(54) **VERWENDUNG EINES TARGETS FÜR DAS FUNKENVERDAMPFEN UND VERFAHREN ZUM HERSTELLEN EINES FÜR DIESE VERWENDUNG GEEIGNETEN TARGETS**
USE OF A TARGET FOR SPARK EVAPORATION, AND METHOD FOR PRODUCING A TARGET SUITABLE FOR SAID USE
UTILISATION D'UNE CIBLE POUR LE DÉPÔT PAR ÉVAPORATION PAR ARC, ET PROCÉDÉ DE FABRICATION D'UNE CIBLE CONVENANT À CETTE UTILISATION

(30) Priorität: 17.08.2008 EP 08014592; 09.10.2008 EP 08017715
(43) Veröffentlichungstag der Anmeldung: 01.06.2011
(73) Patentinhaber: Oerlikon Surface Solutions AG, Trübbach, 9477 Trübbach (CH)
(72) Erfinder: KURAPOV, Denis, CH-8880 Walenstadt (CH); LECHTHALER, Markus, 6800 Feldkirch (AT)
(74) Vertreter: Kempkens, Anke
(86) Internationale Anmeldenummer: PCT/EP2009/005803
(87) Internationale Veröffentlichungsnummer: WO 2010/020362

(56) Entgegenhaltungen:
- EP-A1- 1 722 003

## Beschreibung

Die Erfindung betrifft die Verwendung eines Targets in einer Beschichtungsanlage zur Beschichtung von Metalloxid- und/oder Metallnitridschichten durch Funkenverdampfung und ein Verfahren zum Herstellen von Metalloxidschichten durch Funkenverdampfung. Insbesondere betrifft die Erfindung den Betrieb von Targets, die mindestens eine metallischen Komponente und eine keramische Komponente umfassen. Von besonderer Bedeutung ist die Erfindung für Targets, die Aluminium als niederschmelzenden Bestandteil aufweisen.

Die kathodische Funkenverdampfung ist ein seit Jahren etabliertes Verfahren, das zur Beschichtung von Werkzeugen und Bauteilen Anwendung findet und mit dem sowohl metallische Schichten in breiter Vielfalt als auch Metallnitride, -karbide und -karbonitride abgeschieden werden. Bei all diesen Anwendungen sind die Targets Kathode einer Funkenentladung, die bei niedrigen Spannungen und hohen Strömen betrieben wird und mit der das Target-(Kathoden)-Material verdampft wird. Als einfachste und billigste Stromversorgung zum Betreiben der Funkenentladung werden Gleichspannungsversorgungen benutzt.

Problematischer ist die Herstellung von Metalloxiden mittels Funkenverdampfung. Es ist schwierig, eine Gleichstromfunkenentladung in Sauerstoff bzw. sauerstoffhaltiger Atmosphäre zu betreiben, um oxidische Schichten etwa auf Werkzeugen oder Bauteilen abzuscheiden. Es besteht dabei die Gefahr, dass der Prozess aufgrund des Belegens des Targets mit einer isolierenden Schicht kaum noch kontrollierbar wird.

Dies führt auf dem Target dazu, dass sich der elektrisch leitende Bereich, in dem der Funken läuft, einschnürt und es schliesslich zu einem Unterbruch der Funkenentladung kommt.

In US 5 518 597 wird die Herstellung oxidischer Schichten beschrieben, wobei eine Schichtabscheidung bei erhöhten Temperaturen durchgeführt wird und wobei das Verfahren darauf beruht, dass auch die Anode geheizt (800°C - 1200°C) wird, und das Reaktivgas nicht direkt beim Target eingelassen wird. Die hohe Anodentemperatur hält die Anode leitend und ermöglicht einen stabilen Betrieb der Funken.

Ähnlich wie bei der Anode, sollte das Betreiben der Kathode bei erhöhter Temperatur zumindest zu einer Verringerung des Problems der Targetvergiftung führen. Es ist daher wünschenswert, in einer Beschichtungsanlage ein Target bei einer hohen Temperatur betreiben zu können, und zwar vorzugsweise bei Temperaturen, die über dem Schmelzpunkt des im Target verwendeten Metalls liegen.

Erzielt werden kann dies durch die Verwendung eines Targets welches eine Schmelzpunkterhöhung des Targetmaterials aufweist, was zu einer erhöhten Verdampfungsenthalpie für das Targetmaterial führt. Im Stand der Technik ist für die Herstellung von Nitridschichten eine Technik bekannt, bei der das verwendete Target sowohl metallisches Ti als auch elektrisch leitendes TiN enthält, welches zu einer Erhöhung des Targetschmelzpunktes führt. TiN, welches beim Verdampfen abgelöst wird, kann direkt in die Schicht eingebaut werden. Da es sich bei TiN um ein leitendes Material handelt, kann der Funken ungestört auf der Targetoberfläche wandern, und aufgrund der erhöhten Verdampfungsenthalpie des Targetmaterials ist die Differenz der Verdampfungsenthalpie des Targetmaterials und der "vergifteten" Targetoberfläche minimiert.

Auch zur Herstellung von TiAlN-Schichten ist es bekannt, ein Legierungstarget aus Titan und Aluminium zu verwenden, dem elektrisch leitendes Material aus TiN beizgemischt ist, um den Schmelzpunkt zu erhöhen. Soll die Schicht auch noch Chrombestandteile umfassen, so kann ein Target verwendet werden dem auch leitendes CrN beigemischt ist. Gemäß dem Stand der Technik muss das dem metallischen Target beigemischte Material zwei Bedingungen erfüllen: Einerseits muss das Material den elektrischen Strom leiten und andererseits muss das Material Bestandteil der aufzubauenden Schicht sein. Die Nitride der Metalle der IVa-, Va-, VIa - Gruppen des Periodensystems sind leitend, diejenigen der anderen Metalle jedoch nicht. Dies schränkt die Wahl der für diese Technik verwendbaren Materialien natürlich erheblich ein. Eine noch weitergehende Schmelzpunkterhöhung, als sie mit den angesprochenen Materialien möglich ist, gestaltet sich daher schwierig. Noch gravierender ist, dass, falls die aufzubauende Schicht lediglich isolierende Schichten umfasst, gemäss dem Stand der Technik nicht mit der Schmelzpunkterhöhung gearbeitet werden kann.

Dies bedeutet aber letztendlich, dass die oben beschriebene Möglichkeit der Schmelzpunkterhöhung für Al-Targets bisher nicht zur Verfügung stand, da sowohl Aluminiumnitrid als auch Aluminiumoxid nicht elektrisch leitend sind. Die Herstellung von nicht leitenden Schichten (z.B. Oxid), die als metallische Komponente lediglich Aluminium umfassen, gestaltet sich daher nach wie vor schwierig.

Es ist daher die Aufgabe der vorliegenden Erfindung, ein Verfahren anzugeben gemäss dem mittels Funkenverdampfen eine nichtleitende Schicht mit metallischer Komponente auf ein Substrat aufgebracht werden kann.

Erfindungsgemäss wird ein Target verwendet, dessen Matrix aus einem Metall besteht, dessen Nitrid und/oder Oxid nicht elektrisch leitend ist, wobei das Target einen im Vergleich zum Stand der Technik erhöhten Schmelzpunkt aufweisen.

Erfindungsgemäss wird ein Target verwendet in welchem ein nicht leitendes Oxid und/oder Nitrid des Metalls des Targets in die Matrix des Metalls des Targets eingebaut wird.

Dabei ist dem Target nichtleitendes Material derart zugemischt, dass die Oberfläche des Targets nach wie vor makroskopisch gesehen elektrisch leitend ist. Dies ist dadurch gewährleistet, dass der nichtleitende Anteil in eine Matrix des leitenden Grundmaterials eingebaut ist. Die leitende Matrix liegt an der Oberfläche in einem zusammenhängenden Netzwerk, welches bei der erfindungsgemässen Verwendung es dem Funken erlaubt, über das Target hinweg zu wandern.

Gemäß einer bevorzugten Ausführungsform wird ein Target verwendet bei dem in die Aluminiummatrix des Targets nicht leitende Aluminiumoxidpartikel eingebaut sind.

Gemäß noch einer bevorzugten Ausführungsform weisen die Aluminiumoxidpartikel einen Durchmesser auf, welcher kleiner als 100 µm, insbesondere kleiner als 50 µm, ist. Die nichtleitenden Bestandteile sind dabei insbesondere als so feine Partikel ins Target eingebracht, dass makroskopisch gesehen der Targetschmelzpunkt und die notwendige Verdampfungsenthalpie erhöht werden. Ausserdem sollte gewährleistet sein, dass der Schmelzbereich des Funkens mit tieferer Schmelztemperatur (z.B. Aluminium) eingegrenzt wird. Dadurch reduziert sich die Dropletemission.

Vorzugsweise wird ein Target verwendet bei dem der Anteil des Aluminiumoxids in der Aluminiummatrix kleiner als 70 Vol.% ist.

Gemäß noch einer weiteren bevorzugten Ausführungsform handelt es sich bei dem verwendeten Target um ein pulvermetallurgisches Target

Alternativ kann ein aus in Aluminium eingebrachtem Aluminiumoxidpulver bestehendes Target verwendet werden,

Gemäß einer weiteren alternativen Ausführungsform wird ein Target verwendet, welches mittels eines holographischen Strukturierungsverfahrens hergestellt wurde, wobei eine Aluminiumoxidschicht derart strukturiert wird, und die zwischen dem Aluminiumoxid entstehenden Gräben mit Aluminium aufgefüllt wurden.

Es ist darüber hinaus bevorzugt, wenn das verwendete Target eine Aluminiummatrix aufweist, in welche nicht leitende Aluminiumnitridpartikel eingebaut werden.

In dem verwendeten Target liegen vorzugsweise Aluminiumnitridkörner im Wesentlichen einem ersten Korndurchmesser und Aluminiumkörner mit im Wesentlichen einem zweiten Korndurchmesser vor, wobei der erste Korndurchmesser größer als der zweite Korndurchmesser, insbesondere dreimal größer als der zweite Korndurchmesser, ist.

Gemäß noch einer weiteren bevorzugten Ausführungsform beträgt der erste Korndurchmesser ungefähr 120 µm und der zweite Korndurchmesser beträgt ungefähr 40 µm. Erfindungsgemäss wird auch ein Target vorgesehen, welches zum Herstellen von Metalloxidschichten und/oder Metallnitridschichten durch Funkenverdampfung verwendet wird, wobei das Target eine aus einem Metall bestehende Matrix aufweist, in welche elektrisch nicht leitende Oxide und/oder Nitride des Metalls eingebettet sind.

Vorzugsweise beträgt der Anteil der elektrisch nicht leitenden Oxide und/oder Nitride in der Matrix weniger als 70 Vol. %.

Gemäß noch einer bevorzugten Ausführungsform besteht die Matrix aus Aluminium, in welche Aluminiumoxid oder Aluminiumnitrid eingebettet ist.

Im Folgenden wird die Erfindung anhand eines Ausführungsbeispiels unter Bezugnahme auf die Zeichnung detailliert erläutert.
- Fig. 1: zeigt schematisch die Oberfläche eines erfindungsgemäss zu verwendenden Targets mit ca. 120µm grossen, nitrierten Aluminiumkörnern, eingebettet in eine Aluminiumumgebung aus um ca. Faktor 3 kleineren Aluminiumkörnern wie sie der Funken bei der Funkenverdampfung "sieht";
- Fig. 2: zeigt einen Ausschnitt eines mittels holohgraphischer Technik hergestellten erfindungsgemäßen Targets mit regelmässiger Anordung von Aluminiumoxid- Inseln (schraffiert), eingebettet in einem Aluminium - Kreuzgitter (grau hinterlegt)

Eine Ausführungsform der Erfindung wird nun zunächst beispielhaft anhand eines Aluminiumtargets beschrieben. Aluminium ist ein niedrigschmelzendes Material. Soll mittels Funkenverdampfen Aluminiumoxid hergestellt werden, so ist für ein Aluminium Target bei den typischerweise zu verwendenden Verdampfungsbedingungen die Targetvergiftung ein gravierendes Problem. Die Methode der Schmelzpunkterhöhung gemäß dem Stand der Technik ist - wie oben bereits ausgeführt - nicht anwendbar, da Aluminiumoxid einen sehr guten Isolator bildet.

Im erfindungsgemässen Verfahren weisen die Aluminiumoxid-Partikel des Targets eine Grösse von ungefähr 50µm, bevorzugt jedoch maximal 50 µm Durchmesser auf bzw. sollten diesen Durchmesser nicht wesentlich überschreiten um an die typische Grösse eines Funkendurchmessers angepasst zu sein. Aufgrund des höheren Schmelzpunktes löst sich das Aluminiumoxid nicht auf und die Aluminiumpartikel sind in die zusammenhängende Aluminiummatrix eingebettet. Deswegen liegt der Schmelzpunkt des Targets , insbesondere bei der Beschichtungsanwendung umso höher, je grösser der Aluminiumoxid-Anteil im Vergleich zum Aluminium ist. Allerdings hat sich herausgestellt, dass bei einer zu geringen Aluminiumkonzentration die Leitfähigkeit der Targetoberfläche zu gering ist, um ein stabiles FunkenVerdampfen betreiben zu können. In der Ausführungsform wird daher ein Target mit einem Anteil von Alumiuiumoxid, welcher unterhalb von 70 Vol.% liegt, verwendet.

Zur Herstellung des Targets können verschiedene Verfahren verwendet werden. Gemäß einer ersten Ausführungsform kann die Herstellung mittels eines bekannten pulvermetallurigschen Verfahrens erfolgen. Dabei wird Aluminium in feines Pulver zermahlen und Aluminiumoxid in feines Pulver zermahlen.

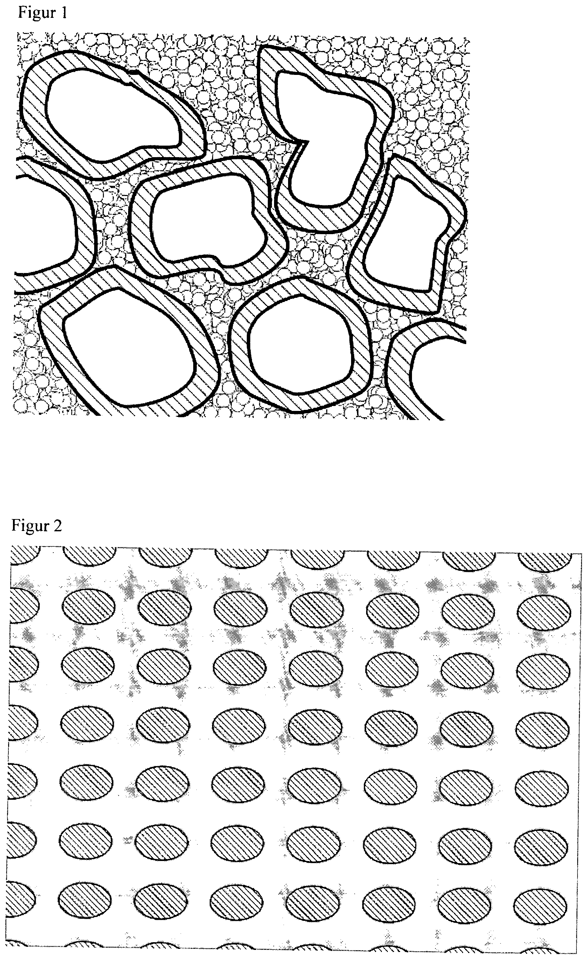

Gemäß eines erfinderischen Verfahrens zur Herstellung eines Targets, welches nun im Zusammenhang mit der Figur 2 beschrieben wird, wird eine holographische Strukturierungsmethode angewandt, wobei eine Aluminiumoxidschicht in Form eines regelmässigen Gitters strukturiert wird. Die dadurch entstehenden Gräben werden dann mit Aluminium ausgefüllt. Vorzugsweise wird das Aluminiumoxid in zwei Richtungen x, y strukturiert, so dass regelmässige Aluminiumoxidinseln entstehen und das Aluminium selbst als Kreuzgitter elektrische Leitfähigkeit in beide Richtungen x, y zulässt.

Solche Oberflächenstrukturen lassen sich grossflächig mit einer Gitterperiode von einigen 10 nm bis einigen 10 µm realisieren. Vorzugsweise wird eine Gitterperiode von 500 nm bis 20 µm verwendet, besonders bevorzugt wird eine Gitterperiode von 2µm verwendet.

Das oben im Zusammenhang mit einer Aluminiummatrix und darin eingebettetem Aluminiumoxid beschriebene Verfahren ist auf jeden elektrischen Isolator anwendbar, sofern dieser in eine leitende Matrix eingebettet wird. Der Begriff Matrix ist dabei im weiten Sinne zu interpretieren, da die Matrix lediglich sicherstellen sollte elektrische Ladungen ableiten zu können, so dass der Fleck des Funkens immer ungehindert auf leitender Oberfläche wandern kann.

Soll eine Schicht mit AlN Bestandteilen aufgebaut werden, so kann auf dieselbe, wie oben beschriebene Art und Weise AlN in einer metallischen Matrix eingebettet werden. Ausserdem ist es möglich, die beschriebene erfinderische Massnahme zur Schmelzpunkterhöhung mit der aus dem Stand der Technik bekannten Massnahme zu kombinieren. Beispielsweise kann, um eine TiAlN - Schicht mittels Funkenverdampfung herzustellen, ein Target verwendet werden, in dem als Bestandteile metallisches Ti, metallisches Al, die leitende Verbindung TiN und der Isolator AlN integriert sind.

Mit dieser Beschreibung soll aber noch ein weiterer Aspekt der vorliegenden Erfindung verdeutlicht werden. Dem Fachmann ist bekannt, dass die Anreicherung von metallischen Aluminiumkörnern mit Sauerstoff aufgrund der Oxidhaut, welche als Diffusionsbarriere wirkt, Schwierigkeiten bereitet.

Bekanntlich kann nämlich beim Aluminiumnitrid Stickstoff mehrere 100 nm in Aluminium diffundieren, d.h. es ist AlN nach der Entstehung an der Oberfläche genügend durchlässig, so dass weiterer Stickstoff in tiefere Regionen des Aluminiums diffundieren kann. Es ist bekannt dass dies bei Aluminiumoxid nicht möglich ist: Eine erste, oberste und meist lediglich wenige Nanometer dicke Schicht Aluminiumoxid bildet bereits eine starke Diffusionsbarriere für weiteren Sauerstoff, so dass eine weitere, tiefer gehende Oxidation nicht stattfindet. Diese Tatsache, die zwar dazu beiträgt, dass Aluminiumspiegel in der Optik stabil sind, hat in dem hier diskutierten Zusammenhang die negative Konsequenz, dass nicht genügend Aluminiumoxid entsteht.

Um das oben beschriebene Problem im Beschichtungsverfahren zu vermeiden, wird zur Herstellung Aluminium enthaltender Schichten die bevorzugt oxidischer Natur sind gemäß einer Ausführungsform ein Target verwendet, welches in eine Aluminiummatrix eingebettete, fein verteilte Nitrid und Aluminium enthaltende-Partikel umfasst. Diese Partikel sorgen für die Schmelzpunkterhöhung des Targets, die dazu benötigt wird, um das unkontrollierte lokale Aufschmelzen von metallischem, niedrigschmelzendem Aluminium, welches zur Emission von Makropartikeln führt, zu reduzieren. Wird dann beim Funkenverdampfungsprozess Sauerstoff als Prozessgas hinzugegeben, so wurde überraschend festgestellt, dass sich dann im Wesentlichen stickstofffreie Aluminiumoxidschichten bilden. Möglicherweise dissoziiert das AlN und Al geht mit dem angebotenen Sauerstoff eine Verbindung ein.

Entsprechend dem erfindungsgemäßen Beschichtungsverfahren liegt die notwendige Verdampfungsenthalpie der Targets, oberhalb jener des reinen Metalls, jedoch knapp unterhalb jener des Kompositmaterials.

Im Rahmen der vorliegenden Beschreibung wurde dargelegt, dass zur Funkenverdampfung Targets aus Metallen verwendet werden können, deren Nitride und/oder Oxide nicht elektrisch leitend sind, wobei diese Nitride und/oder Oxide in Form feiner, nicht leitender Partikel in eine Matrix 4 des Metalls eingebaut werden können und mit einem dieses Kompositmaterial aufweisenden Target mit erhöhtem Schmelzpunkt Funkenverdampfung betrieben werden kann, wobei das Problem der Funkeneinschnürung oder der Instabilität deutlich abgeschwächt, wenn nicht sogar gänzlich vermieden werden kann.

## Patentansprüche

1. Verwendung eines Targets in einem Funkenverdampfungs-Beschichtungsverfahren zur Herstellung von Metalloxid- und/oder Metallnitridschichten, wobei ein Target verwendet wird, in welchem ein nicht leitendes Oxid und/oder Nitrid eines Metalls des Targets in eine leitende Matrix des Metalls des Targets eingebaut ist, wobei die Matrix des Metalls eine Aluminiummatrix und das Oxid und/oder das Nitrid des Metalls Aluminiumoxid und/oder Aluminiumnitrid ist, wobei jeweils das Aluminiumoxid und/oder das Aluminiumnitrid im Target als in der leitenden Aluminiummatrix eingebaute nicht leitende Partikel aus Aluminiumoxid und/oder aus Aluminiumnitrid vorhanden sind, **dadurch gekennzeichnet, dass**
- die leitende Matrix an der Oberfläche des Targets in einem zusammenhängenden Netzwerk liegt, welches bei der Verwendung es dem Funken erlaubt, über das Target hinweg zu wandern, und
- der Anteil der nicht leitenden Partikel im Target so ausgewählt sind, dass, makroskopisch gesehen, der Targetschmelzpunkt und die notwendigen Verdampfungsenthalpie oberhalb des reines Metalls liegt, und die notwendige Verdampfungsenthalpie unterhalb aber nahmöglich jener des Kompositmaterials aus jeweils Aluminiumoxid und/oder Aluminiumnitrid liegt, wobei der Anteil der nicht leitenden Partikel in der Matrix weniger als 70 Vol.% beträgt.

2. Verwendung eines Targets gemäss Anspruch 1, wobei der Schmelzbereich des Targets mit tieferer Schmelztemperatur so eingegrenzt ist, dass sich dadurch die Dropletemission reduziert.

3. Verwendung eines Targets gemäss Anspruch 1, wobei die Verwendung die Herstellung einer stickstofffreien Aluminiumoxidschicht umfasst, wobei das Target Aluminiumnitridpartikel enthält und während des Funkenverdampfungs-Beschichtungsverfahrens Sauerstoff als Prozessgas hinzugegeben wird.

4. Verfahren zum Herstellen eines Aluminiumoxid-enthaltenden Targets welches für die Verwendung gemäss irgendeinem der Ansprüche 1 bis 2 geeignet ist, wobei das Target mittels eines holographischen Strukturierungsverfahrens hergestellt wird, wobei eine Aluminiumoxidschicht in Form eines Gitters strukturiert wird, und wobei die in dem Gitter entstehenden Gräben mit Aluminium aufgefüllt werden.

## Claims

1. Use of a target in a spark evaporation coating process for producing metal oxide and/or metal nitride coatings, wherein a target is used in which a non-conducting oxide and/or nitride of a metal of the target is integrated in a conducting matrix of the metal of the target, wherein the matrix of the metal is an aluminum matrix and the oxide and/or the nitride of the metal is aluminum oxide and/or aluminum nitride, wherein the aluminum oxide and/or the aluminum nitride is/are available in the target in the form of non-conducting particles of aluminum oxide and/or aluminum nitride embedded in the conducting aluminum matrix, **characterized in that**
- the conducting matrix lies at the surface of the target in a cohesive network which, if used, allows the spark to move about across the target, and
- the percentage of the non-conducting particles in the target are chosen such that, as seen macroscopically, the target's melting point and the necessary evaporation enthalpy are above the pure metal, and the necessary evaporation enthalpy is below, but as close as possible to, the composite material consisting of aluminum oxide and/or aluminum nitride, wherein the percentage of the non-conducting particles in the matrix is less than 70 Vol.-%.

2. Use of a target according to claim 1, wherein the target's melting range having a lower melting temperature is limited in such a way that the droplet emission will be reduced thereby.

3. Use of a target according to claim 1, wherein the use comprises the production of a nitrogen-free aluminum oxide layer, wherein the target comprises aluminum nitride particles and during the spark evaporation coating process oxygen is added as process gas.

4. Method for producing a target containing aluminum oxide which is suitable for the use according to one of the claims 1 to 2, wherein the target is produced by means of a holographical structuring method, wherein an aluminum oxide layer is structured in the form of a lattice, and wherein the grooves forming in the lattice are filled up with aluminum.

## Revendications

1. Utilisation d'une cible dans un procédé de revêtement d'évaporation d'étincelles pour produire des couches d'oxyde métallique et/ou de nitrure métallique, une cible étant utilisée dans laquelle un oxyde et/ou nitrure non conducteur d'un métal de la cible est intégré dans une matrice conductrice du métal de la cible, la matrice du métal étant une matrice d'aluminium et l'oxyde et/ou le nitrure du métal étant de l'oxyde d'aluminium et/ou du nitrure d'aluminium, l'oxyde d'aluminium et/ou le nitrure d'aluminium dans la cible étant présent(s) sous forme de particules de l'oxyde d'aluminium et/ou du nitrure d'aluminium non conductrices qui sont intégrées dans la matrice d'aluminium conductrice, **caractérisé en ce que**
- la matrice conductrice est disposée à la surface de la cible dans un réseau cohérent qui lors de l'utilisation permet à l'étincelle de se déplacer à travers la cible, et
- le pourcentage des particules non conductrices dans la cible est choisi de manière que, du point de vue macroscopique, le point de fusion de la cible et l'enthalpie d'évaporation nécessaire est au-dessus du métal pur, et l'enthalpie d'évaporation nécessaire est au-dessous, mais le plus proche possible, du matériau composite comprenant respectivement de l'oxyde d'aluminium et/ou du nitrure d'aluminium, le pourcentage des particules non conductrices dans la matrice étant inférieur à 70 Vol.%.

2. Utilisation d'une cible selon la revendication 1, la plage de fusion de la cible ayant une température de fusion plus basse étant limitée de telle manière que l'émission de gouttelettes se réduit ainsi.

3. Utilisation d'une cible selon la revendication 1, l'utilisation comprenant la production d'une couche d'oxyde d'aluminium exempte d'azote, la cible contenant des particules de nitrure d'aluminium et pendant le procédé de revêtement d'évaporation d'étincelles l'oxygène étant ajouté comme gaz de procédé.

4. Procédé de production d'une cible contenant de l'oxyde d'aluminium qui est appropriée pour l'utilisation selon l'une des revendications 1 à 2, la cible étant produite au moyen d'un procédé de structuration holographique, une couche d'oxyde d'aluminium étant structurée sous forme d'une grille, et les fossés apparaissant dans la grille étant remplis avec de l'aluminium.
